# EUROPÄISCHE PATENTSCHRIFT

(11) **EP 2 733 806 B1**
(45) Veröffentlichungstag und Bekanntmachung des Hinweises auf die Patenterteilung: **16.12.2015**
(21) Anmeldenummer: 13003825.0
(22) Anmeldetag: 01.08.2013
(51) Int. Cl.: H02H 7/08, H03K 17/687

(54) **Brückenschaltung mit einer erhöhten Ausfallssicherheit**
Bridge circuit with increased reliability
Circuit en pont avec une sécurité élevée contre les pannes

(30) Priorität: 19.11.2012 DE 102012022495
(43) Veröffentlichungstag der Anmeldung: 21.05.2014
(73) Patentinhaber: Micronas GmbH, 79108 Freiburg (DE)
(72) Erfinder: Albrecht, Stefan, 67294 Mauchenheim (DE)
(74) Vertreter: Koch Müller Patentanwaltsgesellschaft mbH

(56) Entgegenhaltungen:
- DE-A1-102009 004 556
- US-A1- 2005 281 065
- US-A1- 2009 146 595
- US-B1- 7 768 317
- KHALID AMBUSAIDI ET AL: "New Circuit Topology for Fault Tolerant H-Bridge DCâ DC Converter", IEEE TRANSACTIONS ON POWER ELECTRONICS, IEEE SERVICE CENTER, PISCATAWAY, NJ, US, Bd. 25, Nr. 6, 1. Juni 2010 (2010-06-01), Seiten 1509-1516, XP011298676, ISSN: 0885-8993
- PENG XIAO ET AL: "Seven-Level Shunt Active Power Filter for High-Power Drive Systems", IEEE TRANSACTIONS ON POWER ELECTRONICS, IEEE SERVICE CENTER, PISCATAWAY, NJ, US, Bd. 24, Nr. 1, 1. Januar 2009 (2009-01-01) , Seiten 6-13, XP011250037, ISSN: 0885-8993

## Beschreibung

Die Erfindung betrifft eine Brückenschaltung mit einer erhöhten Ausfallssicherheit gemäß dem Oberbegriff des Patentanspruchs 1.

Aus der DE 10 2007 063 434 A1, der DE 10 2007 060 380 B3, der DE 10 2005 044 526 A1, der EP 1 764 907 A1 und der US 2 625 458 sind verschiedene Brückenschaltungen und insbesondere Halbbrücken bekannt. Des Weiteren sind aus Khalid Ambusaidi et al: "New Circuit Topology for Fault Tolerant H-Bridge DC a DC Converter", IEEE Transactions on Power Electronics, IEEE Service Cener, Piscataway, NJ, US Bd. 25, Nr. 6, 1.Juni 2010, Seiten 1509-1516, aus Peng Xiao et al "Seven-Level Shunt Active Power Filer for High Power Drive Systems", IEEE Transactions on Power Electronics, IEEE Service Cener, Piscataway, NJ, US Bd. 24, Nr. 61, 1.Januar 2009, Seiten 6-13, der DE 10 2009 004556 A1, der US 7 768 317 B1 und der US 2005 / 281065 A1 weitere Schaltungen bekannt. Insbesondere wird mit den Brückenschaltungen die Richtung des Stromflusses durch einen elektrischen Verbraucher geändert. Hierbei sind insbesondere Elektromotoren oder Wechselrichter für die Solartechnik ein wichtiges Einsatzgebiet derartigen Brückenschaltungen.

Vor diesem Hintergrund besteht die Aufgabe der Erfindung darin, eine Vorrichtung anzugeben, die den Stand der Technik weiterbildet.

Die Aufgabe wird durch eine Brückenschaltung mit einer erhöhten Ausfallssicherheit mit den Merkmalen des Patentanspruchs 1 gelöst. Vorteilhafte Ausgestaltungen der Erfindung sind Gegenstand von Unteransprüchen.

Gemäß der Erfindung wird eine Brückenschaltung mit einer erhöhten Ausfallssicherheit bereitgestellt, wobei die Brückenschaltung einen ersten elektrischen Verbraucher mit einem ersten Anschlusskontakt und einem zweiten Anschlusskontakt aufweist, und des Weiteren eine erste Serienschaltung mit einem ersten Schalter und mit einen zweiten Schalter vorgesehen ist, wobei die erste Serienschaltung mit einem ersten Knoten und mit einem zweiten Knoten verschaltet ist, und eine zweite Serienschaltung mit einem dritten Schalter und mit einem vierten Schalter vorgesehen ist, und die zweite Serienschaltung mit einem dritten Knoten und mit einem vierten Knoten verschaltet ist, und eine dritte Serienschaltung mit einem fünften Schalter und mit einem sechsten Schalter vorgesehen ist, und die dritte Serienschaltung mit dem zweiten Knoten und mit einem fünften Knoten ver schaltet ist, und eine vierte Serienschaltung mit einem siebten Schalter und mit einem achten Schalter vorgesehen ist, wobei die vierte Serienschaltung mit dem vierten Knoten und mit einem sechsten Knoten verschaltet ist, und wobei der erste Knoten und der dritte Knoten mit einer Versorgungsspannung verschaltet sind, und der fünfte Knoten und der sechste Knoten mit einem Bezugspotential verschaltet sind, und der erste Anschlusskontakt mit dem zweiten Knoten verschaltet ist und der zweite Anschlusskontakt mit dem vierten Knoten verschaltet ist. Es sei angemerkt, dass unter dem Begriff integrierte Brückenschaltung eine Brückenschaltung verstand wird, deren Schalter als integrierte Bauelemente in einer Halbleitervorrichtung ausgebildet ist. Vorzugsweise werden die Schalter hierbei als MOS-Schalter ausgebildet und in einem gemeinsamen Gehäuse ausgebildet sind. Derartige integrierte Brückenschaltungen werden insbesondere für das Schalten von hohen Strömen eingesetzt. Vorliegend wird unter dem Begriff der hohen Ströme vorzugsweise Ströme oberhalb ein Ampere, höchst vorzugsweise Ströme oberhalb von 10 Ampere verstanden. Des Weiteren sei darauf hingewiesen, dass in jedem Zweig der Brückenschaltung sowohl auf der Versorgungsspannungsseite als auch auf der Masseseite jeweils zwei Schalter in dem jeweiligen Zweig in Serie geschaltet sind. Des Weiteren sei angemerkt, dass mit dem Begriff "verschaltet" eine niederohmige Verbindung zwischen zwei Schaltungsteilen verstanden wird. Mit einer niederohmigen Verbindung wird hierbei eine Verbindung mit einem Widerstandswert unterhalb von 10 Ohm verstanden. Derartige niederohmige Verbindungen lassen sich auch als Kurzschluss auffassen.

Der Erfindung wird eine Brückenschaltung mit einer erhöhten Ausfallssicherheit bereitgestellt, wobei die Brückenschaltung einen ersten elektrischen Verbraucher mit einem ersten Anschlusskontakt und einem zweiten Anschlusskontakt aufweist und die Brückenschaltung eine erste Serienschaltung mit einem ersten Schalter und mit einen zweiten Schalter umfasst, wobei die erste Serienschaltung mit einem ersten Knoten und mit einem zweiten Knoten verschaltet ist, und die Brückenschaltung eine zweite Serienschaltung mit einem dritten Schalter und mit einem vierten Schalter umfasst, wobei die zweite Serienschaltung mit einem dritten Knoten und mit einem vierten Knoten verschaltet ist, und des Weiteren eine dritte Serienschaltung mit einem fünften Schalter und mit einem sechsten Schalter vorgesehen ist, wobei die dritte Serienschaltung mit dem zweiten Knoten und mit einem fünften Knoten verschaltet ist, und wobei eine vierte Serienschaltung mit einem siebten Schalter und mit einem achten Schalter vorgesehen ist, wobei die vierte Serienschaltung mit dem vierten Knoten und mit einem sechsten Knoten verschaltet ist, und wobei der erste Knoten und der dritte Knoten mit einer Versorgungsspannung verschaltet sind, und der fünfte Knoten und der sechste Knoten mit einem Bezugspotential verschaltet sind, wobei eine fünfte Serienschaltung mit einem neunten Schalter und einem zehnten Schalter vorgesehen ist, und eine sechste Serienschaltung mit einem elften Schalter und einem zwölften Schalter vorgesehen ist, und ein siebenter Knoten zwischen dem ersten Schalter und dem sechsten Schalter vorgesehen ist, und des Weiteren ein achter Knoten zwischen dem fünften Schalter und dem sechsten Schalter vorgesehen ist, und ein neunter Knoten zwischen dem dritten Schalter und dem vierten Schalter vorgesehen ist, und des Weiteren ein zehnter Knoten zwischen dem siebten Schalter und dem achten Schalter vorgesehen ist, und ferner ein elfter Knoten zwischen dem neunten Schalter und dem zehnten Schalter vorgesehen ist, und ein zwölfter Knoten zwischen dem elften Schalter und dem zwölften Schalter vorgesehen ist, wobei der elfte Knoten und der zwölfte Knoten miteinander verschaltet sind, und die fünfte Serienschaltung an einem Ende mit dem Knoten und mit dem gegenüberliegenden Ende mit dem Knoten verschaltet ist, und des Weiteren die sechste Serienschaltung an einem Ende mit dem Knoten und mit dem gegenüberliegenden Ende mit Knoten verschaltet ist, und der erste Anschlusskontakt mit dem zweiten Knoten und der zweite Anschlusskontakt mit dem elften Knoten verschaltet ist.

Ein Vorteil der erfindungsgemäßen Vorrichtung ist es, dass in jedem Zweig der Brückenschaltung eine Redundanz bei den Schaltern vorhanden ist. Untersuchungen haben gezeigt, dass insbesondere Schalter mit denen hohe Ströme geschaltet werden, sich nach einiger Zeit nicht mehr öffnen lassen, d.h. einen Kurzschluss darstellen. Beispielsweise liegt bei den besonders häufig verwendeten MOS-Halbleiterschaltern der Fehler in vielen Fällen darin, dass die Source - Drain Strecke kurzgeschlossen ist. Indem in jedem Zweig der Brückenschaltung zwei Schalter zueinander in Serie liegen, lässt sich Ausfallwahrscheinlichkeit reduzieren. Gerade bei Brückschaltungen, welche in schwer zugänglichen Systemen eingebaut sind, führt eine erhöhte Ausfallsicherheit zu einer wesentlichen Verringerung der Wartungskosten.

Erfindungsgemäß ist eine siebente Serienschaltung mit einem dreizehnten Schalter und einem vierzehnten Schalter vorgesehen, wobei ein dreizehnter Knoten zwischen den beiden Schaltern der siebenten Serienschaltung angeordnet ist und des Weiteren eine achte Serienschaltung mit einem fünfzehnten Schalter und einem sechszehnten Schalter vorgesehen ist und ein vierzehnter Knoten zwischen den beiden Schaltern der achten Serienschaltung angeordnet ist und die siebente Serienschaltung an einem Ende mit dem Knoten und mit dem gegenüberliegenden Ende mit dem Knoten verschaltet ist, und die achte Serienschaltung an einem Ende mit dem Knoten und mit dem gegenüberliegenden Ende mit Knoten verschaltet ist, und der dreizehnte Knoten und der vierzehnte Knoten miteinander verschaltet sind, und wobei der Verbraucher mit dem dreizehnten Knoten verschaltet ist.

Erfindungsgemäß umfasst der Verbraucher eine dreiphasige Vorrichtung. Derartige Vorrichtungen sind vorzugsweise als induktive Lasten, insbesondere als Elektromotoren ausgebildet.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine erste Ausführungsform der erfindungsgemäßen integrierten Brückenschaltung,
- Figur 2: eine zweite Ausführungsform der erfindungsgemäßen integrierten Brückenschaltung,
- Figur 3: eine dritte Ausführungsform der erfindungsgemäßen integrierten Brückenschaltung.

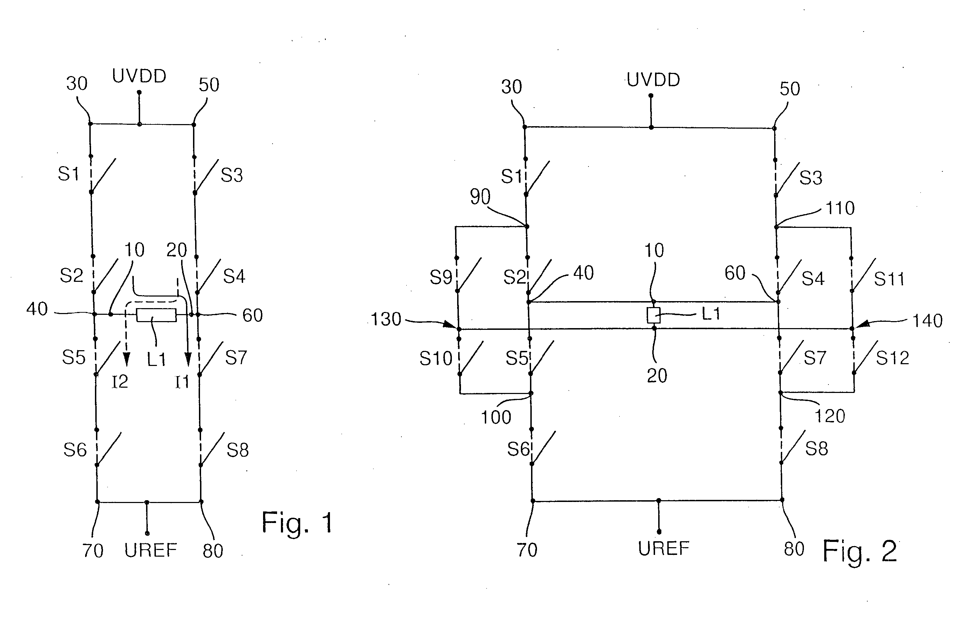

Die Abbildung der Figur 1 zeigt eine erste Ausführungsform einer erfindungsgemäßen integrierten Brückenschaltung mit einer erhöhten Ausfallssicherheit aufweisend, einen ersten elektrischen Verbraucher L1 mit einem ersten Anschlusskontakt 10 und einem zweiten Anschlusskontakt 20, und eine erste Serienschaltung mit einem ersten Schalter S1 und mit einen zweiten Schalter S2, wobei die erste Serienschaltung mit einem ersten Knoten 30 und mit einem zweiten Knoten 40 verschaltet ist, und des Weiteren weist die integrierte Brückenschaltung eine zweite Serienschaltung mit einem dritten Schalter S3 und mit einem vierten Schalter S4 auf, wobei die zweite Serienschaltung mit einem dritten Knoten 50 und mit einem vierten Knoten 60 verschaltet ist.

Des Weiteren ist eine dritte Serienschaltung mit einem fünften Schalter S5 und mit einem sechsten Schalter S6 vorgesehen, wobei die dritte Serienschaltung mit dem zweiten Knoten 40 und mit einem fünften Knoten 70 verschaltet ist. Ferner ist eine vierte Serienschaltung mit einem siebten Schalter S7 und mit einem achten Schalter S8 vorgesehen, wobei die vierte Serienschaltung mit dem vierten Knoten 60 und mit einem sechsten Knoten 80 verschaltet ist. Ferner sind der erste Knoten und 30 und der dritte Knoten 50 mit einer Versorgungsspannung UVDD verschaltet, sowie der fünfte Knoten 70 und der sechste Knoten 80 mit einem Bezugspotential UREF verschaltet. Des Weiteren sind der erste Anschlusskontakt 10 mit dem zweiten Knoten 40 und der zweite Anschlusskontakt 20 mit dem vierten Knoten 60 verschaltet.

Sind in einen ersten Zustand der erste Schalter S1, der zweite Schalter S2, der dritte Schalter S3 und der vierte Schalter S4 geschlossen und der dritte Schalter S3, der vierte Schalter S4, der fünfte Schalter S5 und der sechste Schalter S6 geöffnet, fließt ein Strom I1 durch den elektrischen Verbraucher L1 und entsprechend fließt in einem zweiten Zustand ein Strom I2, wenn der der erste Schalter S1, der zweite Schalter S2, der dritte Schalter S3 und der vierte Schalter S4 geöffnet und der dritte Schalter S3, der vierte Schalter S4, der fünfte Schalter S5 und der sechste Schalter S6 geschlossen sind. Hierdurch lässt sich also die Richtung des Stromflusses durch den elektrischen Verbraucher L1 ändern. Ist der Verbraucher L1 beispielsweise als induktive Last in Form eines Elektromotors ausgebildet, lässt sich durch eine Änderung der Schalterstellung von dem ersten Zustand zu dem zweiten Zustand die Drehrichtung des einphasigen Motors ändern.

Die Abbildung der Figur 2 zeigt eine zweite Ausführungsform einer erfindungsgemäßen integrierten Brückenschaltung. Im Folgenden die Unterschiede zu der ersten Ausführungsform, dargestellt in der Abbildung der Figur 1, erläutert. Der zweite Knoten 40 ist nun mit dem vierten Knoten 60 verschaltet. Ferner ist eine fünfte Serienschaltung mit einem neunten Schalter S9 und einem zehnten Schalter S10 vorgesehen, sowie eine sechste Serienschaltung mit einem elften Schalter S11 und einem zwölften Schalter S12 vorgesehen. Des Weiteren ist ein siebenter Knoten 90 zwischen dem ersten Schalter S1 und dem sechsten Schalter S6 vorgesehen und ein achter Knoten 100 zwischen dem fünften Schalter S5 und dem sechsten Schalter S6 vorgesehen sowie ein neunter Knoten 110 zwischen dem dritten Schalter S3 und dem vierten Schalter S4 vorgesehen.

Außerdem ist ein zehnter Knoten 120 zwischen dem siebten Schalter S7 und dem achten Schalter S8 vorgesehen und ein elfter Knoten 130 zwischen dem neunten Schalter S9 und dem zehnten Schalter S10 vorgesehen. Ferner ist ein zwölfter Knoten 140 zwischen dem elften Schalter S11 und dem zwölften Schalter S12 vorgesehen, wobei der elfte Knoten 130 und der zwölfte Knoten 140 miteinander verschaltet sind. Der erste Anschlusskontakt 10 des ersten elektrischen Verbrauchers L1 ist mit dem zweiten Knoten 40 bzw. mit dem vierten Knoten 60 verschaltet und der zweite Anschlusskontakt 20 des ersten elektrischen Verbrauchers ist mit dem elften Knoten 130 bzw. mit dem zwölften Knoten 140 verschaltet.

Folglich liegen der erste Schalter S1, der dritte Schalter S3, der sechste Schalter S6 und der achte Schalter S8 jeweils in Serie zu einem der beiden Zweige einer Halbrückenschaltung. Ein Vorteil ist, dass auch wenn sich irgend ein Schalter innerhalb einer der beiden Zweige der Halbrückenschaltung nicht mehr öffnen lässt, lässt sich ein weiterer Stromfluss mittels eines Öffnen des in Serie liegenden Schalters unterbinden. Hierbei bleibt die Brückenschaltung weiter funktionsfähig.

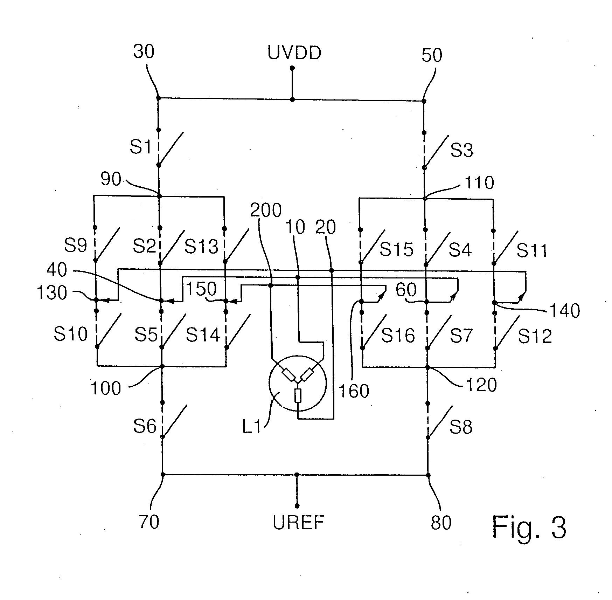

Die Abbildung der Figur 3 zeigt eine dritte Ausführungsform einer erfindungsgemäßen integrierten Brückenschaltung. Im Folgenden werden die Unterschiede zu der ersten Ausführungsform, dargestellt in der Abbildung der Figur 2, erläutert. Es ist eine siebente Serienschaltung mit einem dreizehnten Schalter S13 und einem vierzehnten Schalter S14 vorgesehen, und ein dreizehnter Knoten 150 zwischen den beiden Schaltern S13, S14 der siebenten Serienschaltung angeordnet. Ferner ist eine achte Serienschaltung mit einem fünfzehnten Schalter S15 und einem sechszehnten Schalter S16 vorgesehen, und ein vierzehnter Knoten 160 zwischen den beiden Schaltern S15, S16 der achten Serienschaltung angeordnet. Die siebente Serienschaltung ist an einem Ende mit dem Knoten 90 und mit dem gegenüberliegenden Ende mit dem Knoten 100 verschaltet und die achte Serienschaltung ist an einem Ende mit dem Knoten 110 und mit dem gegenüberliegenden Ende mit Knoten 120 verschaltet. Außerdem sind der dreizehnte Knoten 150 und der vierzehnte Knoten 160 miteinander verschaltet sind, wobei der Verbraucher L1 einen dritten Anschlusskontakt 200 aufweist und mit dem dritten Anschlusskontakt mit dem dreizehnten Knoten 150 bzw. dem vierzehnten Konten 160 verschaltet ist.

## Patentansprüche

1. Brückenschaltung mit einer erhöhten Ausfallssicherheit aufweisend, einen ersten elektrischen Verbraucher (L1) mit einem ersten Anschlusskontakt (10) und einem zweiten Anschlusskontakt (20), wobei der Verbraucher (L1) eine dreiphasige Vorrichtung umfasst und
- eine erste Serienschaltung mit einem ersten Schalter (S1) und mit einen zweiten Schalter (S2) vorgesehen ist, wobei die erste Serienschaltung mit einem ersten Knoten (30) und mit einem zweiten Knoten (40) verschaltet ist, und
- eine zweite Serienschaltung mit einem dritten Schalter (S3) und mit einem vierten Schalter (S4) vorgesehen ist, wobei die zweite Serienschaltung mit einem dritten Knoten (50) und mit einem vierten Knoten (60) verschaltet ist,
- eine dritte Serienschaltung mit einem fünften Schalter (S5) und mit einem sechsten Schalter (S6) vorgesehen ist, wobei die dritte Serienschaltung mit dem zweiten Knoten (40) und mit einem fünften Knoten (70) verschaltet ist,
- eine vierte Serienschaltung mit einem siebten Schalter (S7) und mit einem achten Schalter (S8) vorgesehen ist, wobei die vierte Serienschaltung mit dem vierten Knoten (60) und mit einem sechsten Knoten (80) verschaltet ist, und wobei
der erste Knoten und (30) und der dritte Knoten (50) mit einer Versorgungsspannung (UVDD) verschaltet sind, und
der fünfte Knoten (70) und der sechste Knoten (80) mit einem Bezugspotential (UREF) verschaltet sind, **dadurch gekennzeichnet**, das
- eine fünfte Serienschaltung mit einem neunten Schalter (S9) und einem zehnten Schalter (S10) vorgesehen ist, und
- eine sechste Serienschaltung mit einem elften Schalter (S11) und einem zwölften Schalter (S12) vorgesehen ist, und
ein siebenter Knoten (90) zwischen dem ersten Schalter (S1) und dem sechsten Schalter (S6) vorgesehen ist, und
ein achter Knoten (100) zwischen dem fünften Schalter (S5) und dem sechsten Schalter (S6) vorgesehen ist, und
ein neunter Knoten (110) zwischen dem dritten Schalter (S3) und dem vierten Schalter (S4) vorgesehen ist, und
ein zehnter Knoten (120) zwischen dem siebten Schalter (S7) und dem achten Schalter (S8) vorgesehen ist, und
ein elfter Knoten (130) zwischen dem neunten Schalter (S9) und dem zehnten Schalter (S10) vorgesehen ist, und
ein zwölfter Knoten (140) zwischen dem elften Schalter (S11) und dem zwölften Schalter (S12) vorgesehen ist, wobei der elfte Knoten (130) und der zwölfte Knoten (140) miteinander verschaltet sind, und
die fünfte Serienschaltung an einem Ende mit dem Knoten (90) und mit dem gegenüberliegenden Ende mit dem Knoten (100) verschaltet ist, und die sechste Serienschaltung an einem Ende mit dem Knoten (110) und mit dem gegenüberliegenden Ende mit Knoten (120) verschaltet ist, und
der erste Anschlusskontakt (10) mit dem zweiten Knoten (40) und der zweite Anschlusskontakt (20) mit dem elften Knoten (130) verschaltet ist, und
eine siebente Serienschaltung mit einem dreizehnten Schalter (S13) und einem vierzehnten Schalter (S14) vorgesehen ist, und ein dreizehnter Knoten (150) zwischen den beiden Schaltern (S13, S14) der siebenten Serienschaltung angeordnet ist,
eine achte Serienschaltung mit einem fünfzehnten Schalter (S15) und einem sechszehnten Schalter (S16) vorgesehen ist, und ein vierzehnter Knoten (160) zwischen den beiden Schaltern (S15, S16) der achten Serienschaltung angeordnet ist,
die siebente Serienschaltung an einem Ende mit dem Knoten (90) und mit dem gegenüberliegenden Ende mit dem Knoten (100) verschaltet ist, und die achte Serienschaltung an einem Ende mit dem Knoten (110) und mit dem gegenüberliegenden Ende mit Knoten (120) verschaltet ist, und
der dreizehnte Knoten (150) und der vierzehnte Knoten (160) miteinander verschaltet sind, und
wobei der Verbraucher (L1) einen dritten Anschlusskontakt (200) aufweist und der dritte Anschlusskontakt (200) mit dem dreizehnten Knoten (150) bzw. mit dem vierzehnten Knoten (160) verschaltet ist, und
wobei der Verbraucher (L1) mit dem dreizehnten Knoten (150) verschaltet ist.

2. Brückenschaltung nach Anspruch 1, **dadurch gekennzeichnet, dass** der Verbraucher (L1) eine induktive Last umfasst.

## Claims

1. Bridge circuit with increased fail safety, comprising
a first electrical load (L1) with a first connecting contact (10) and a second connecting contact (20), wherein the load (L1) comprises a three-phase device and
- a first series circuit with a first switch (S1) and a second switch (S2) is provided, wherein the first series circuit is connected with a first junction (30) and a second junction (40), and
- a second series circuit with a third switch (S3) and a fourth switch (S4) is provided, wherein the second series circuit is connected with a third junction (50) and a fourth junction (60),
- a third series circuit with a fifth switch (S5) and a sixth switch (S6) is provided, wherein the third series circuit is connected with the second junction (40) and a fifth junction (70), and
- a fourth series circuit with a seventh switch (S7) and an eighth switch (S8) is provided, wherein the fourth series circuit is connected with the fourth junction (60) and a sixth junction (80),
wherein the first junction (30) and the third junction (50) are connected with a supply voltage (UVDD) and the fifth junction (70) and sixth junction (80) are connected with a reference potential (UREF),
**characterised in that**
- a fifth series circuit is provided with a ninth switch (S9) and a tenth switch (S10),
- a sixth series circuit is provided with an eleventh switch (S11) and a twelfth switch (S12),
- a seventh junction (90) is provided between the first switch (S1) and the sixth switch (S6),
- an eighth junction (100) is provided between the fifth switch (S5) and the sixth switch (S6),
- a ninth junction (110) is provided between the third switch (S3) and the fourth switch (S4),
- a tenth junction (120) is provided between the seventh switch (S7) and the eighth switch (S8),
- an eleventh junction (130) is provided between the ninth switch (S9) and the tenth switch (S10),
- a twelfth junction (140) is provided between the eleventh switch (S11) and the twelfth switch (S12), wherein the eleventh junction (130) and the twelfth junction (140) are connected together,
- the fifth series circuit is connected at one end with the junction (90) and at the opposite end with the junction (100),
- the sixth series circuit is connected at one end with the junction (110) and at the opposite end with the junction (120),
- the first connecting contact (10) is connected with the second junction (40) and the second connecting contact (20) is connected with the eleventh junction (130),
- a seventh series circuit with a thirteenth switch (S13) and a fourteenth switch (S14) is provided and a thirteenth junction (150) is arranged between the two switches (S13, S14) of the seventh series circuit,
- an eighth series circuit with a fifteenth switch (S15) and a sixteenth switch (S16) is provided and a fourteenth junction (160) is arranged between the two switches (S15, S16) of the eighth series circuit,
- the seventh series circuit is connected at one end with the junction (90) and at the opposite end with the junction (100),
- the eighth series circuit is connected at one end with the junction (110) and at the opposite end with the junction (120), and
- the thirteenth junction (150) and the fourteenth junction (160) are connected together,
wherein the load (L1) has a third connecting contact (200) and the third connecting contact (200) is connected with the thirteenth junction (150) or the fourteenth junction (160) and wherein the load (L1) is connected with the thirteenth junction (150).

2. Bridge circuit according to claim 1, **characterised in that** the load (L1) comprises and inductive load.

## Revendications

1. Circuit en pont avec une sécurité accrue contre les pannes, présentant
un premier consommateur électrique (L1) avec un premier contact de raccordement (10) et un deuxième contact de raccordement (20), dans lequel le consommateur (L1) comprend un dispositif triphasé et
- il est prévu un premier circuit série avec un premier interrupteur (S1) et avec un deuxième interrupteur (S2), dans lequel le premier circuit série est connecté à un premier noeud (30) et à un deuxième noeud (40), et
- il est prévu un deuxième circuit série avec un troisième interrupteur (S3) et avec un quatrième interrupteur (S4), dans lequel le deuxième circuit série est connecté à un troisième noeud (50) et à un quatrième noeud (60),
- il est prévu un troisième circuit série avec un cinquième interrupteur (S5) et avec un sixième interrupteur (S6), dans lequel le troisième circuit série est connecté au deuxième noeud (40) et à un cinquième noeud (70),
- il est prévu un quatrième circuit série avec un septième interrupteur (S7) et avec un huitième interrupteur (S8), dans lequel le quatrième circuit série est connecté au quatrième noeud (60) et à un sixième noeud (80), et dans lequel le premier noeud (30) et le troisième noeud (50) sont connectés à une tension d'alimentation (UVDD), et
le cinquième noeud (70) et le sixième noeud (80) sont connectés à un potentiel de référence (UREF),
**caractérisé en ce que**
- il est prévu un cinquième circuit série avec un neuvième interrupteur (S9) et avec un dixième interrupteur (S10), et
- il est prévu un sixième circuit série avec un onzième interrupteur (S11) et avec un douzième interrupteur (S12), et
il est prévu un septième noeud (90) entre le premier interrupteur (S1) et le sixième interrupteur (S6), et
il est prévu un huitième noeud (100) entre le cinquième interrupteur (S5) et le sixième interrupteur (S6), et
il est prévu un neuvième noeud (110) entre le troisième interrupteur (S3) et le quatrième interrupteur (S4), et
il est prévu un dixième noeud (120) entre le septième interrupteur (S7) et le huitième interrupteur (S8), et
il est prévu un onzième noeud (130) entre le neuvième interrupteur (S9) et le dixième interrupteur (S 10), et
il est prévu un douzième noeud (140) entre le onzième interrupteur (S11) et le douzième interrupteur (S 12), dans lequel le onzième noeud (130) et le douzième noeud (140) sont connectés l'un à l'autre, et
le cinquième circuit série est connecté à une extrémité au noeud (90) et à l'extrémité opposée au noeud (100), et
le sixième circuit série est connecté à une extrémité au noeud (110) et à l'extrémité opposée au noeud (120), et
le premier contact de raccordement (10) est connecté au deuxième noeud (40) et le deuxième contact de raccordement (20) est connecté au onzième noeud (130), et
il est prévu un septième circuit série avec un treizième interrupteur (S 13) et avec un quatorzième interrupteur (S14), et un treizième noeud (150) est disposé entre les deux interrupteurs (S13, S 14) du septième circuit série,
il est prévu un huitième circuit série avec un quinzième interrupteur (S15) et avec un seizième interrupteur (S16), et un quatorzième noeud (160) est disposé entre les deux interrupteurs (S 15, S16) du huitième circuit série,
le septième circuit série est connecté à une extrémité au noeud (90) et à l'extrémité opposée au noeud (100), et
le huitième circuit série est connecté à une extrémité au noeud (110) et à l'extrémité opposée au noeud (120), et
le treizième noeud (150) et le quatorzième noeud (160) sont connectés l'un à l'autre, et dans lequel le consommateur (L1) présente un troisième contact de raccordement (200) et le troisième contact de raccordement (200) est connecté au treizième noeud (150) ou au quatorzième noeud (160), et
dans lequel le consommateur (L1) est connecté au treizième noeud (150).

2. Circuit en pont selon la revendication 1, **caractérisé en ce que** le consommateur (L1) comprend une charge inductive.
